Europäisches Patentamt

European Patent Office

Office européen des brevets

(11) Publication number: **0 143 532**
**A1**

# EUROPEAN PATENT APPLICATION

(21) Application number: **84306630.9**

(51) Int. Cl.⁴: **G 01 R 33/035**

(22) Date of filing: **28.09.84**

(30) Priority: **05.10.83 GB 8326581**

(43) Date of publication of application: **05.06.85**
Bulletin **85/23**

(84) Designated Contracting States: **DE FR NL**

(71) Applicant: **PICKER INTERNATIONAL LIMITED, East Lane, Wembley Middlesex HA9 7PR (GB)**

(72) Inventor: **Barnard, Bryan Robert, 997 Harrow Road, Sudbury Wembley Middlesex (GB)**

(74) Representative: **Pope, Michael Bertram Wingate, Central Patent Department Wembley Office The General Electric Company, p.l.c. Hirst Research Centre East Lane, Wembley Middlesex HA9 7PP (GB)**

(54) **Apparatus for detecting variations in magnetic fields.**

(57) A superconducting gradiometer apparatus for detecting variations in magnetic fields including a pick-up coil arrangement (5, 7, 9) provided with one or more trim tabs (19) of a resistive material arranged so as to compensate for variations in the coupling between the coil arrangement and the field due to changes in eddy currents produced in adjacent objects by the field as the frequency of the field varies.

EP 0 143 532 A1

Apparatus for detecting variations in magnetic fields

This invention relates to apparatus for detecting variations in an applied magnetic field.

More particularly the invention relates to such apparatus of the kind known as a superconducting gradiometer.

A superconducting gradiometer essentially comprises a pick-up coil arrangement designed to be insensitive to uniform field gradients, and a signal amplifying and processing arrangement responsive to the output of the pick-up coil arrangement. The signal amplifying and processing arrangement is commonly referred to as a superconducting quantum interference device (SQUID).

The pick-up coil arrangement essentially comprises two or more coils connected in series whose cross-sectional areas, numbers of turns and relative positions are such that in the absence of the magnetic field variation to be detected the voltages induced in the different coils balance giving a zero resultant input to the SQUID.

Fine control of the required pick-up coil balance is normally achieved by placing small tabs of a superconducting material near to the pick-up coils. These have the effect of either increasing or decreasing the coupling of sections of the pick-up coils to the external noises and signals. By careful positioning of these tabs with respect to the coils the required balance may be achieved, as is described, for example, in Section IVB of an article entitled Biomagnetic Instrumentation by G.L.Romani, S.J.Williamson and L.Kaufman at page 1815 of Review of Scientific Instruments Vol. 53 No. 12, December 1982.  Such superconducting trim tabs, however, may only be used to give perfect balance for an applied magnetic field at one frequency, the applied field usually being static or of very low frequency.  At other frequencies the balance is degraded by eddy currents which are induced in any electrically conducting objects in the vicinity of the pick-up coils.  These may be the materials used in the construction of the system itself, such as the r.f. shield or aluminised thermal insulation, or external objects such as furniture and building materials.  In particular the conductivity of the ground below the measurement area may contribute large eddy current fields.

It is an object of the present invention to provide a superconducting gradiometer arrangement including means for improving pick-up coil balance with variation of the frequency of the applied magnetic field.

According to the present invention in a superconducting gradiometer there is provided adjacent at least one coil of a pick-up coil arrangement of the gradiometer, at least one tab consisting of a resistive material and arranged so that due to the presence of the tab the coupling between an applied magnetic field and the coil to which the tab is adjacent varies with variations of frequency of the applied field in such a manner as to compensate for variations in coupling between said coil and said field with said frequency variations in the applied field, which variations in coupling are due to changes in eddy currents produced in other adjacent objects by said applied field.

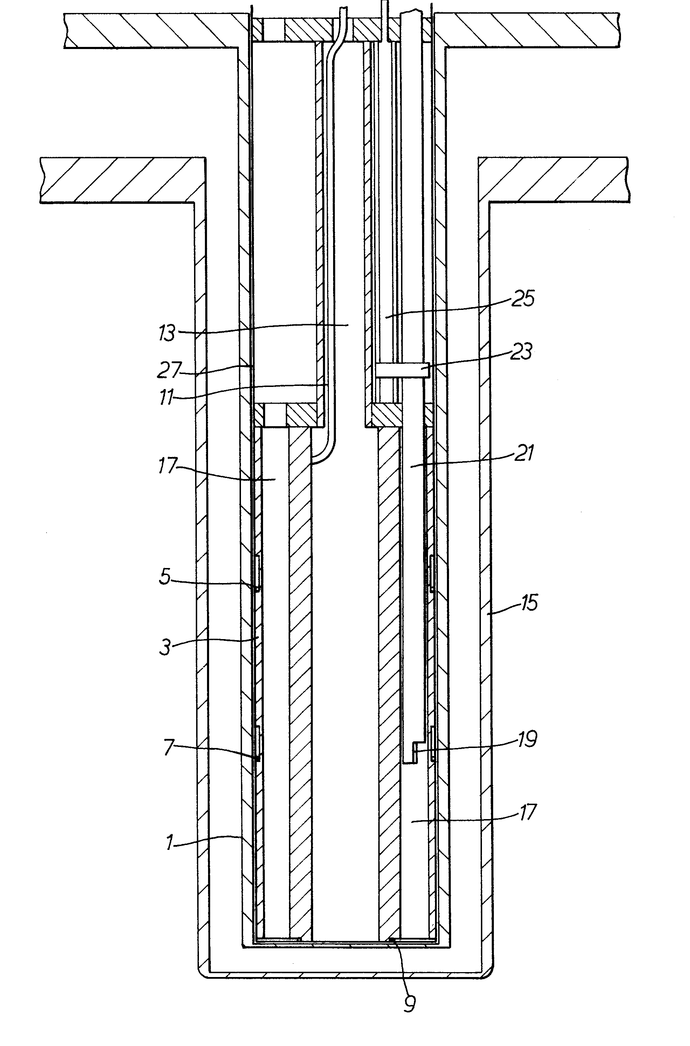

One superconducting gradiometer in accordance with the invention will now be described by way of example with reference to the accompanying drawing which is a diagrammatic sectional view of a pick-up coil arrangement forming part of the gradiometer.

Referring to the drawing, the pick-up coil arrangement is housed in an inner casing 1. Within the casing 1 there is a tubular coil former 3 which carries on its outer surface the coils 5, 7 and 9 of the arrangement.

In accordance with known practice the coils 5, 7 and 9 are designed so as to supply to a SQUID (not shown) when connected in series, a signal which may be utilised by the SQUID to detect minute variations in a magnetic field applied to the coils in a direction parallel to the axis of the coil former 3. The output signal from the coils 5, 7 and 9 is supplied to the SQUID via leads (not shown) carried in a lead tube 11 extending through a passage 13 extending between the end of the former 3 and the end of the casing 1.

In operation the casing 1 is filled with liquid helium (not shown) to maintain it at a temperature approaching absolute zero, the SQUID being similarly maintained at a low temperature in operation. The casing 1 is surrounded by an outer casing 15, the space between the two casings 1 and 15 being evacuated to provide a thermal insualting vacuum space around the casing 1.

The coil former 3 is provided with a number of axial bores 17 in which may be inserted trim tabs supported on the ends of rods, one such tab 19 and support rod 21 only being shown in the drawing for the sake of clarity. Each rod 21 is provided with a lug 23 having a threaded hole through which passes a rod 25 having a screw thread so that the axial position of the tab 19 within the former 1 may be adjusted by rotation of the rod 25.

Some of the tabs 19 consist of a superconducting material such as lead, whilst, in accordance with the present invention, others of the tabs 21 consist of a resistive material, such as copper or aluminium, or other electrically conducting non superconducting material.

The coil arrangement is normally provided with an r.f. shield. This is suitably positioned between the casing 1 and the coil former, and at the end of the casing adajcent the SQUID is arranged so as to adjoin a similar r.f. shield around the SQUID, the shield being indicated by reference 27 in the drawing.

The superconducting material tabs are used in known manner to balance the pick-up coil arrangement output for static or low frequency applied magnetic fields, the superconducting tabs having the property that no magnetic field lines pass through them so that, when a tab is placed adjacent a coil, the total flux coupled to the coil is very slightly altered.

When the applied field is of other than a low frequency, the coupling of a coil to the applied field may change with frequency due to variation of the eddy currents induced by the field in objects adjacent the coil, such as the r.f. shield, or furniture or building materials in the room in which the apparatus is housed, or even the ground below the apparatus.

In accordance with the invention one or more tabs of resistive material are positioned adjacent one or more of the coils to compensate for any such dynamic imbalance which may be observed. The material and dimensions of the resistive tabs are selected and the tabs positioned so that the change in the coupling of a coil to the field with frequency due to the resistive tab or tabs matches the change in the coupling of the coil with frequency due to such eddy currents, at least over a range of frequencies of interest. It will be appreciated that this is possible by the use of resistive tabs, as opposed to superconducting tabs, since the effect on coupling of a resistive tab changes with frequency, since the eddy currents induced in a resistive tab change with frequency, whereas the effect on coupling of a superconducting tab does not change with frequency.

CLAIMS

1.      A superconducting gradiometer characterised in that there is provided adjacent at least one coil of a pick-up coil arrangement (5, 7, 9) of the gradiometer at least one tab (19) consisting of a resistive material and arranged so that due to the presence of the tab the coupling between an applied magnetic field and the coil to which the tab is adjacent varies with variations of frequency of the applied field in such a manner as to compensate for variations in coupling between said coil and said field with said frequency variations in the applied field, which variations in coupling are due to changes in eddy currents produced in other adjacent objects by said applied field.

2.      A superconducting gradiometer according to Claim 1 wherein said tab (19) consists of copper.

3.      A superconducting gradiometer according to Claim 1 wherein said tab (19) consists of aluminium.

4.      A superconducting gradiometer according to any one of the preceding claims wherein said pick-up coil arrangement (5,7,9) is carried on a tubular coil former (3) and said tab (19) is housed within an axial bore (17) in the wall of the coil former.

5.      A superconducting gradiometer according to Claim 4 wherein said tab (19) is supported on a rod (21) disposed in said bore (17), and means (23, 25) is provided for adjusting the axial position of said rod within said bore.

6.      A superconducting gradiometer according to Claim 5 wherein said means for adjusting the axial position of said rod comprises an axially rotatable threaded rod (25) which passes through a threaded hole in a member (23) secured to said first-mentioned rod (21).

1/1

0143532

| | DOCUMENTS CONSIDERED TO BE RELEVANT | | EP 84306630.9 |
|---|---|---|---|
| Category | Citation of document with indication, where appropriate, of relevant passages | Relevant to claim | CLASSIFICATION OF THE APPLICATION (Int. Cl.4) |
| X | FR - A1 - 2 512 965 (CONSIGLIO NAZIONALE DELLE RICERCHE) | 1,4-6 | G 01 R 33/035 |
| A | * Page 4, line 9 - page 6, line 4; fig. 3,3A,3B,6,7 * | 2,3 | |
| | ---- | | |
| | | | **TECHNICAL FIELDS SEARCHED (Int. Cl.4)** |
| | | | G 01 R 33/00 H 01 L 39/00 |

The present search report has been drawn up for all claims

| Place of search VIENNA | Date of completion of the search 06-12-1984 | Examiner KUNZE |
|---|---|---|